Europäisches Patentamt

European Patent Office

Office européen des brevets

(11) Publication number: **0 480 373 A2**

# EUROPEAN PATENT APPLICATION

(21) Application number: **91117135.3**

(22) Date of filing: **08.10.91**

(51) Int. Cl.5: **H01L 29/784**, H01L 29/60, H01L 29/62

(30) Priority: **09.10.90 JP 271262/90**
**09.10.90 JP 271263/90**
**09.10.90 JP 271264/90**
**26.11.90 JP 321805/90**
**28.11.90 JP 328090/90**

(43) Date of publication of application:
**15.04.92 Bulletin 92/16**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Iwamatsu, Seiichi**
**c/o Seiko Epson Corporation, 3-5, Owa**
**3-chome**
**Suwa-shi, Nagano-ken(JP)**

(74) Representative: **Blumbach Weser Bergen**
**Kramer Zwirner Hoffmann Patentanwälte**
**Radeckestrasse 43**
**W-8000 München 60(DE)**

(54) **Thin-film semiconductor device.**

(57) Disclosed is a thin-film semiconductor device wherein a semiconductor thin-film (13) is formed on an insulating film (12) that has been formed on the surface of a semiconductor substrate (11) doped with a high-concentration active impurity and a semiconductor device is formed on the semiconductor thin-film. Thereby the electrical characteristics of thin-film semiconductor devices can be stabilized.

FIG. 1

EP 0 480 373 A2

The present invention relates to a thin-film semiconductor device and, more particularly, to the structure of thin-film semiconductor devices formed over an insulating layer which in turn is formed on a semiconductor substrate.

In a prior art thin-film semiconductor device, an insulating layer is formed on a semiconductor substrate surface and a semiconductor thin film is formed on the insulating layer. The semiconductor device is formed on the semiconductor thin film.

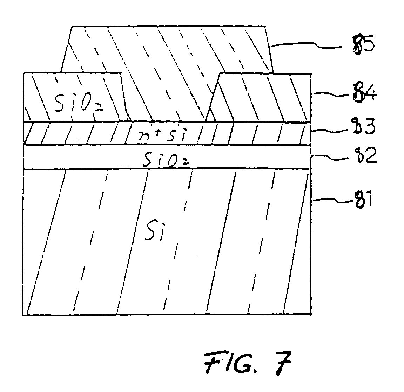

In the prior art thin-film semiconductor device, a contact structure such as that shown in the cross section in Fig. 7 is often used. That is, on the surface of an Si substrate 81, about 500 $\mu$m thick, an $SiO_2$ film 82, about 0.5 $\mu$m thick, is formed. On the $SiO_2$ film 82 an Si film 83, about 0.1 $\mu$m thick, is formed. On the Si film 83 a CVD $SiO_2$ film 84, about 0.5 $\mu$m thick, is formed and provided with a contact hole, about 2 $\mu$m in diameter, by wet etching. An electrode 85 is connected through the contact hole.

References

1) K. Isumi., et al., Electron. Lett., 14, p. 593 (1978).

2) K. Terrill, et. al., IEDM, p. 294 (1988).

However, in the above prior art technologies, the type of semiconductor substrate was not consistent, and therefore the electrical characteristics (e.g., threshold voltage of MOS FETs) of the thin-film semiconductor substrate were not consistent.

The invention is intended to solve this problem of the prior art technologies, and its purpose is to offer a thin-film semiconductor device structure that will yield consistent electrical characteristics.

In the above prior art technologies, particularly in the case of submicron channel lengths caused by the substrate floating effect of thin-film MOS FETs, the breakdown voltage between the source and drain would decrease.

The invention is further intended to solve this problem, and to offer a new thin-film semiconductor device structure for preventing the decrease in the threshold voltage between the source and drain in submicron channel lengths caused by the substrate floating effect in thin-film MOS FETs.

Further, there was also a problem with a decreased withstand voltage between the source and drain when the channel length of a thin-film MOS FET would enter the submicron range due to the substrate floating effect.

The invention is further intended to solve this prior art problem, and to offer a new thin-film MOS FET structure that will not have decreased the breakdown voltage between the source and drain at submicron channel lengths due to the substrate floating effect in thin-film MOS FET.

Also, in the above prior art technologies, when the contact hole diameter was less than 2 $\mu$m, dry etching had to be used, and in that case etching could easily advance to the Si film, which would remove the Si film at the bottom of the contact hole and prevent connection of the electrode.

The invention is also intended to solve this problem, and to offer a new contact hole structure that will ensure reliable connection of the semiconductor thin-film substrate and electrode in a thin-film semiconductor device.

These objects are achieved by a thin-film semiconductor device as claimed.

Embodiments of the invention will be explained in detail below with reference to the drawings, in which:

Fig. 1 and Fig. 2

are cross sections of embodiments of the invention showing the principal parts of thin-film semiconductor device;

Fig. 3

is a cross section and a schematic diagram of another embodiment showing a thin-film C-MOS FET inverter circuit;

Fig. 4

is a cross section of another embodiment showing a thin-film MOS FET;

Fig. 5 and Fig. 6

are cross sections of embodiments showing the contact parts of thin-film semiconductor devices, and

Fig. 7

is a cross section of the contact part of a thin-film semiconductor device of the prior art.

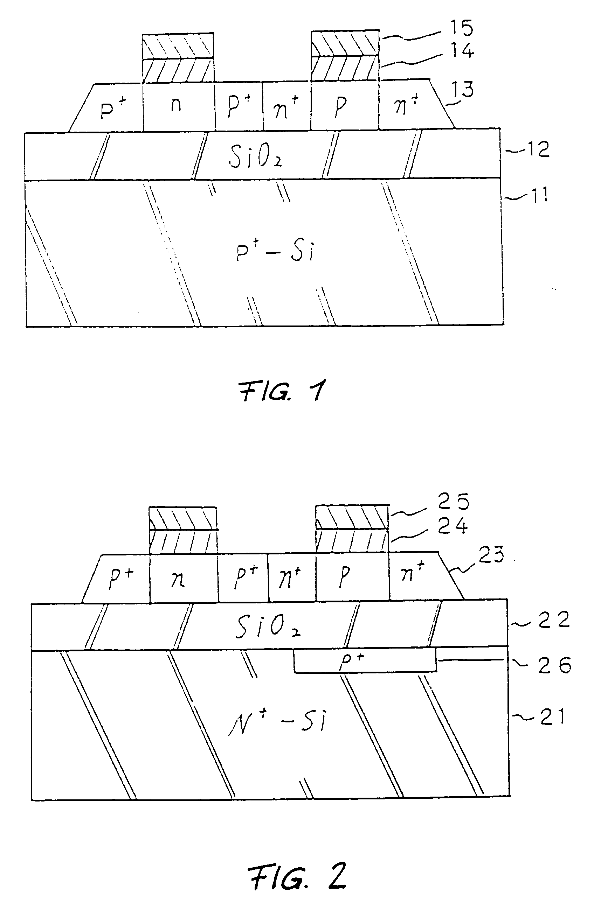

Fig. 1 is a cross section of an embodiment of the invention showing the principal parts of a C-MOS FET (thin-film transistor). That is, the C-MOS FET is formed by forming a gate $SiO_2$ film 14 and gate electrode 15 on an Si thin-film 13. The Si thin-film 13 is formed on an $SiO_2$ film 12 which in turn is formed on the surface of an Si substrate 11 doped with a $p^+$-type high-concentration active impurity. In this embodiment, the threshold voltage of the n-channel MOS FET can be maintained consistently high by minimizing the work function difference between the p-type Si of the Si thin-film 13 and the $p^+$-type Si of the Si substrate 11 by means of a high electron mobility. The active impurity of the Si substrate 11 can be either $p^+$-type or $n^+$-type; a $p^+$-type diffusion layer or an $n^+$-type diffusion layer may be formed on the surface of the Si substrate 11 and used as an electrode and a potential supplied to the diffusion layer.

Fig. 2 is a cross section of another embodiment of the invention showing the principal parts of a C-MOS FET. An $SiO_2$ film 22 is formed on the surface of an Si substrate 21 doped with an $n^+$-type high-concentration active impurity, and the C-MOS FET is made by forming a gate $SiO_2$ film 24, gate electrode 25, etc., on an Si thin-film 23 formed

on the $SiO_2$ film 22. In this embodiment, a $p^+$-type diffusion layer 26 is formed below the n-channel MOS FET. An $n^+$-type diffusion layer may be used below the p-channel MOS FET, diffusion layers of different conductivity types may be used below both channels, and the diffusion layer may be $n^+$-type below n-channel MOS FETs and $p^+$-type below p-channel MOS FETs. The action of either one keeps the threshold voltage of the C-MOS FET constant. Further, an electrode can be formed from the diffusion layer 26, etc., and used to apply a potential to the diffusion layer and control and stabilize the electrical characteristics (threshold voltage, etc.) of the thin-film semiconductor device.

In addition to MOS FETs, the invention can be applied to bipolar transistors. For example, by providing a $p^+$-type or an $n^+$-type active impurity layer below at least the base region of a lateral bipolar TFT, the current gain $h_{fe}$ can be stabilized.

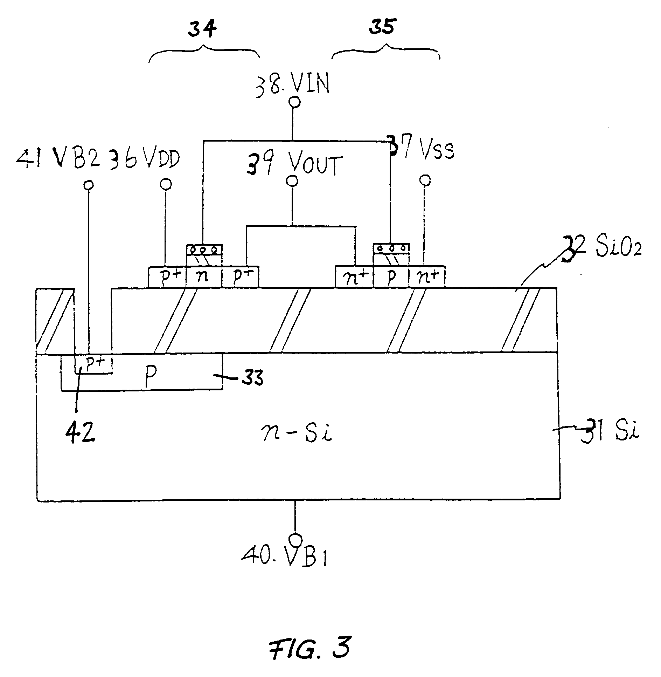

Fig. 3 is a cross section and a schematic diagram of another embodiment of the invention showing an inverter circuit made of thin-film C-MOS FETs. A p-channel MOS FET 34 and n-channel MOS FET 35 are formed as thin-film semiconductor devices on the surface of an n-type Si substrate 31 with an $SiO_2$ film 32 between them. A p-type diffusion layer 33 is formed by ion implantation on the surface of the Si substrate 31 below the p-channel MOS FET 34. When the Si substrate 31 is a p-type Si, the diffusion layer 33 is formed on the surface of the Si substrate 31 below the p-channel MOS FET 35 by ion implantation of an n-type impurity. A reverse voltage is impressed between electrode 41 (VB2) and electrode 40 (VB1) in order to prevent punch-through due to the substrate floating effect of the p-channel MOS FET 34 and the n-channel MOS FET 35 at the pn-junction formed by the diffusion layer 33 and the substrate 31. In Fig. 3, VDD at electrode 37 is the circuit board voltage, VIN at electrode 38 is the input voltage and VOUT at electrode 39 is the output voltage of the C-MOS FET inverter circuit. Further, 41 (VB2) is an electrode that passes through a contact hole in the $SiO_2$ film 32 to a high-concentration diffusion layer 42 formed in the diffusion layer 33.

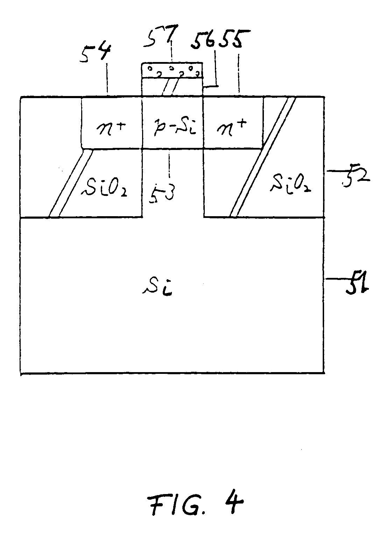

Fig. 4 is a cross section of another embodiment of the invention showing a thin-film MOS FET. An insulating film 52 is formed on the surface of a semiconductor substrate 51, the MOS FET comprising a semiconductor film substrate 53, a source region 54, a drain region 55, a gate insulating film 56 and a gate electrode 57 and is formed on the insulating film 52. The semiconductor film substrate 53 is connected to the semiconductor substrate 51 through a contact hole in the insulating film 52.

The connection region of the semiconductor film substrate 53 and the semiconductor substrate 51 should be formed in a self-aligned manner as in the figure, but it may be formed overlapping the source region 54. The semiconductor substrate 1 need not be of the same conductivity type as the semiconductor film substrate 53 and may be a polycrystalline or amorphous semiconductor high-resistance film. The semiconductor substrate 51 below an n-channel MOS FET may have a p-type C-MOS FET structure and the semiconductor substrate 51 below an p-channel MOS FET may have an n-type C-MOS structure.

Fig. 5 is a cross section of yet another embodiment of the invention showing the contact parts of a thin-film semiconductor device. On the surface of an Si substrate 61 are formed in this order an $SiO_2$ film 62, an Si film 63 and a CVD $SiO_2$ film 64. The lower Si film 63 is over-etched through a contact hole in the $SiO_2$ film 64 and a thin Si film, W film or TiN film is formed by CVD so that it is connected to the side wall 66 of the etched Si film, after which a thick Al film is deposited to form an electrode 65, connected to the side wall 66 of the Si film 63.

The Si film side wall 66 need not exist around the entire circumference of the contact hole, and it need only be present in one part of the contact hole to form the connection with the electrode 65.

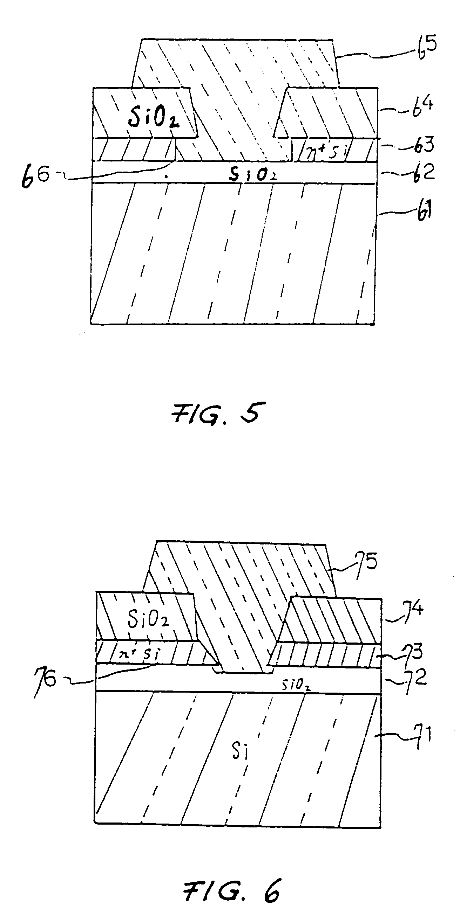

Fig. 6 is a cross section of still another embodiment of the invention showing the contact structure of a thin-film semiconductor device. On the surface of an Si substrate 71 are formed in this order an $SiO_2$ film 72, an Si film 73 and a CVD $SiO_2$ film 74. By forming an electrode 75 after forming a contact hole by dry etching using a $CHF_3$ gas plasma and by etching the Si film 73 so that its protruding part 76 is formed in a slanted or trapezoidal shape by either making the selection ratio for dry etching of the $SiO_2$ and Si 20 to 1 or performing wet etching using a hydro fluoric acid solution upon completion of dry etching, a reliable contact between the Si film 73 and the electrode 75 can be assured in mass production.

The Si film 73 need not exist around the entire circumference of the contact hole as long as at least a part is remaining, and the protruding part 76 need only be formed in one part and not around the entire circumference of the contact hole.

By means of the invention as described above, the electrical characteristics of thin-film semiconductor devices can be stabilized.

Further, by means of the invention, punchthrough due to the substrate floating effect can be prevented in thin-film MOS FETs of thin-film semiconductor devices by impressing a substrate voltage, and the threshold voltage can also be controlled.

Further, by means of the invention, a decreased breakdown voltage due to hole injection from the drain caused by short-channeling of the thin-film MOS FET can be avoided by flowing out holes to the semiconductor substrate.

Also by means of the invention, the semiconductor thin-film substrate and the electrode of thin-film semiconductor devices can be reliably connected and a contact structure for thin-film semiconductor devices can be offered that is readily mass produced.

**Claims**

1. A thin-film semiconductor device wherein a semiconductor thin-film (13) is formed on an insulating film (12) that has been formed on the surface of a semiconductor substrate (11) doped with a high-concentration active impurity and a semiconductor device is formed on the semiconductor thin-film.

2. The thin-film semiconductor device of claim 1 wherein the high-concentration active impurity is $p^+$- type or $n^+$-type.

3. The thin-film semiconductor device of claim 1 or 2 wherein the semiconductor substrate doped with a high-concentration active impurity is a $p^+$-type active impurity diffusion layer (26) or an $n^+$-type active impurity-diffusion layer.

4. A thin-film semiconductor device wherein an n-channel MOS FET is formed over an insulating layer (32) in an n-type semiconductor substrate region, and a p-channel MOS FET is formed over the insulating layer in a p-type semiconductor substrate region.

5. A thin-film semiconductor device wherein the semiconductor film substrate (53) of a thin-film MOS FET is connected to a semiconductor substrate (51) with an insulating layer (52) between them.

6. A thin-film semiconductor device having an insulating film (64) formed on the surface of a semiconductor thin-film substrate (63) wherein at least an electrode film formed by CVD is connected to the sidewall (66) of the semiconductor thin-film substrate the sidewall being formed by etching the semiconductor thin-film substrate through a contact hole in the insulating film.

7. A thin-film semiconductor device wherein an insulating layer (74) is formed on the surface of a semiconductor thin-film substrate (73), a contact hole is provided in the insulating layer (74), the semiconductor thin-film substrate being etched through said contact hole to overhang from the sidewall of the contact hole and an electrode is provided self-aligned to the overhanging part of the semiconductor thin-film substrate.

FIG. 1

FIG. 2

34    35

38. VIN

41 VB2  36 VDD    39 VOUT    37 Vss

32 SiO2

| p+ | n | p+ |    | n+ | p | n+ |

| P+ |    P    33

42    n - Si    31 Si

40. VB1

FIG. 3

FIG. 4

FIG. 5

FIG. 6

FIG. 7